Europäisches Patentamt

European Patent Office

Office européen des brevets

(19)

(11) **EP 0 426 657 B1**

(12) **EUROPEAN PATENT SPECIFICATION**

(45) Date of publication and mention
of the grant of the patent:
**10.03.1999 Bulletin 1999/10**

(51) Int Cl.6: **H03M 13/00**

(21) Application number: **91200210.2**

(22) Date of filing: **19.12.1984**

(54) **Method and apparatus for decoding error correction code**

Verfahren und Vorrichtung zur Dekodierung eines Fehler-Korrektur-Code

Méthode et appareil pour décoder un code de correction d'erreur

(84) Designated Contracting States:
**AT CH DE FR GB LI NL SE**

(30) Priority: **20.12.1983 JP 240525/83**
**23.12.1983 JP 198079/83 U**

(43) Date of publication of application:
**08.05.1991 Bulletin 1991/19**

(62) Document number(s) of the earlier application(s) in
accordance with Art. 76 EPC:
**85900195.0 / 0 167 627**

(73) Proprietor: **SONY CORPORATION**
**Tokyo 141 (JP)**

(72) Inventors:
• **Ozaki, Shinya**
**Shinagawa-ku Tokyo (JP)**
• **Odaka, Kentaro**
**Shinagawa-ku Tokyo (JP)**
• **Fukami, Tadashi**
**Shinagawa-ku Tokyo (JP)**

(74) Representative: **Senior, Alan Murray et al**
**J.A. KEMP & CO.,**
**14 South Square,**
**Gray's Inn**
**London WC1R 5LX (GB)**

(56) References cited:
GB-A- 2 093 238          US-A- 3 714 629
US-A- 4 044 328          US-A- 4 107 650
US-A- 4 142 174          US-A- 4 205 324

• ELECTRONICS AND COMMUNICATIONS IN
JAPAN, vol.9, no.66, September 1983, NEW
YORK US pages 28 - 35 IMAI ET AL 'Decoding
method for doubly encoded Reed-Solomon
codes and their probabilities'
• NTC'77 CONFERENCE RECORD, vol.3, 1977,
NEW-YORK, N.Y., US pages 36-2-1 - 36-2-7
ROBERT BOYD, BIBB CAIN & GEORGE CLARK
'A concatenated coding approach for high data
rate applications'
• IEEE TRANSACTIONS ON INFORMATION
THEORY, vol.18, no.1, January 1972, NEW YORK
US pages 182 - 185 SUDHAKAR REDDY & JOHN
ROBINSON 'Random error and burst correction
by iterated codes'
• RADIO AND ELECTRONIC ENGINEER, vol.52,
no.4, April 1982, LONDON GB pages 188 - 192
FARRELL 'Burst-error correcting array codes'
• IEEE TRANSACTIONS ON INFORMATION
THEORY, vol.11, no.4, OCT. 1965, page 549 - 557,
FORNEY 'ON DECODING BCH CODES'

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

## EP 0 426 657 B1

**Description**

<u>TECHNICAL FIELD</u>

This invention relates to a method and an apparatus for decoding error correction code.

<u>BACKGROUND ART</u>

Product code are well known such that information symbols are arranged in two-dimensional form, error correction codes are encoded for each row and column of the two-dimensional arrangement so that each information symbol is included in two error correction code series. In decoding the product code, the error correction code is decoded for each column and error correction code can be decoded for each row by employing the decoding information. The decoding information is called a pointer.

In the conventional methods since each information symbol is associated with a pointer, it is required that the total number of pointers is at least equal to the number of information symbols.

Further, in the case where erasure correction is made by employing the pointers, since the pointers are read out from a pointer memory and the error value is calculated for every row, there exists a problem in that the number of processing steps such as memory accesses, calculations and so on inevitably increases.

On the other hand, in the case where complicated codes such as BCH codes are employed as error correction codes, since the operations for obtaining error values become inevitably complicated, there exists a problem in that a great number of program steps are required in the case where the calculations are implemented by hardware.

IBM Technical Disclosure Bulletin, Vol. 17, No. 2, July 1974, pages 473-475 discloses an error correction system for taped data in which error pointers from column decoding are used in error correction of rows of the data.

EP-A-0096109 (Tokyo Shibaura Denki K.K.) is part of the state of the art by virtue of Article 54(3) E.P.C. and discloses a decoding method using a single Reed-Solomon-Code.

GB-A- 210749 discloses an error flag decoder in which the storage required for error flags can be reduced by use of a read address counter and frame read counter set with a particular offset and in which error flags can be stored in parity bits for a preceding frame.

IEEE Transactions on Information Theory, Vol. 18, n°1, January 1972, pages 182-185, entitled "Random error and burst correction by iterated codes" by S.M. REDDY et al. describes in paragraph II thereof a method for decoding a product code of C1 (n1,k1) and C2 (n2,k2) Reed-Solomon codes. C1 decoding is first performed and a weight estimating the confidence of the correction is assigned to each column. The positions corresponding to the columns of lowest confidence are considered as erasures and a errors-and-erasures Forney decoding of the C2 codes is then performed on the rows.

An object of this invention is to provide a method and an apparatus for decoding error correction codes which can reduce the number of pointers required in decoding as well as reducing the number of memory regions for the pointers and the number of times the pointers need to be read and written to.

Another object of this invention is to provide a method and an apparatus for decoding error correction code which can markedly reduce the number of processing steps in dependence upon the fact that the pointers with respect to each row are the same.

Still another object of this invention is to provide an apparatus for decoding error correction codes which can reduce the number of calculating steps in an erasure correction.

A further object of this invention is to provide a method for decoding error correction codes which can obtain error values in decoding having a simple construction and a small number of processing steps.

According to the present invention there is provided a method for decoding a product error correction code as defined in claim 1.

The invention also provides an apparatus for decoding a product error correction code as defined in claim 2.

Further, in the present invention, paying attention to the fact that in linear non-dualistic code having a root of 1, one of the syndromes is an addition of (mod. 2) of a received symbol series, the apparatus for decoding error correction code can store a syndrome in a syndrome register and form an error value with respect to a single symbol by subtracting other error values from a value stored in the syndrome register in correcting a plurality of erroneous symbols.

The invention will be further described by way of non-limitative example with reference to the accompanying drawings in which:-

Fig. 1 is a schematic block diagram of an encoder according to an embodiment of the present invention.

Fig. 2 is a schematic block diagram showing the operation of an embodiment of the present invention.

Fig. 3 is a schematic block diagram showing a decoder according to one embodiment of this invention.

Fig. 4 is a block diagram showing an error correcting decoder according to Figure 3.

Fig. 5 is a block diagram of a part of the error location and error value calculating circuit of Figure 4.

Fig. 6 is a block diagram showing a construction of an arrangement for use with this invention.

Fig. 7 is a block diagram for the processing circuit of Fig. 6.

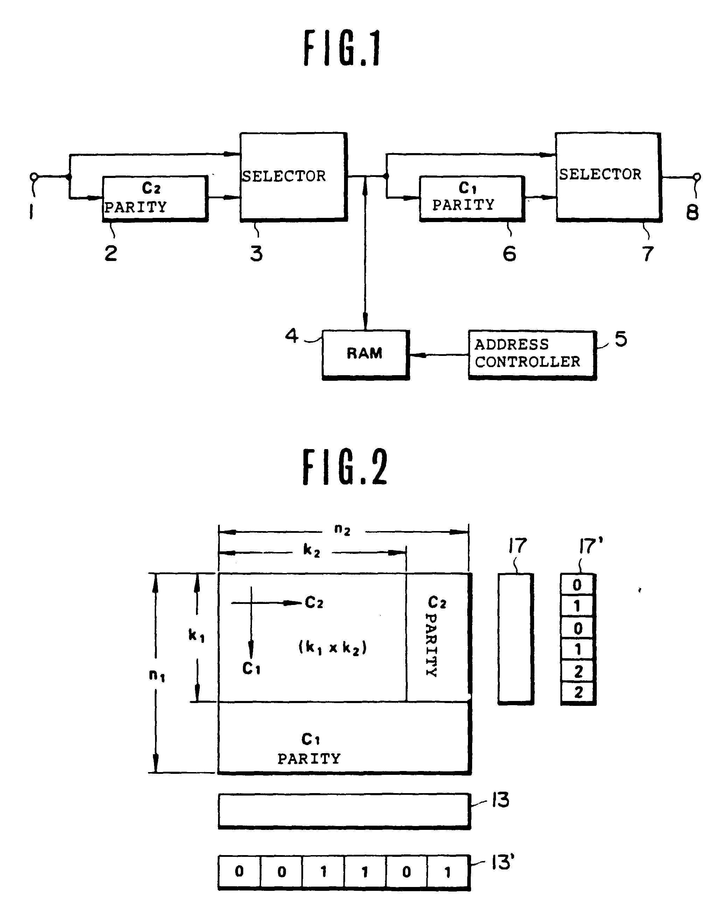

An embodiment of the present invention will be described, referring to the drawings. Fig. 1 shows a structure of an encoder for product code. The reference numeral 1 denotes an input terminal, the reference numeral 2 denotes a second error correction code $C_2$ parity generator. The input data from the input terminal 1 is supplied to the $C_2$ parity generator 2 and one input terminal of a selector 3. The $C_2$ parity data formed by the $C_2$ parity generator 2 is supplied to the other input terminal of the selector 3. The selector 3 repeats $k_1$ times the operations for selecting $(n_2 - k_2)$ parity data after $k_2$ information symbols are selected. During this operation, the information symbols and the parity data are stored in a RAM (Random Access Memory) 4 in sequence under control of an address controller 5.

The data read out from the RAM 4 are supplied to a $C_1$ (the first error correction code) parity generator 6 and one input terminal of a selector 7 and the $C_1$ parity data formed by the $C_1$ parity generator 6 is supplied to the other input terminal of the selector 7. The selector 7 selects $((n_1 - k_1) \times k_2)$ $C_1$ parity data after having selected $(k_1 \times n_2)$ symbols including the $C_2$ parity data. The digital data derived from an output terminal 8 of the selector 7 are transmitted or recorded on a magnetic tape (not shown) with a magnetic head, for instance. In this case, it is possible to write again the encoded output once into the RAM 4 and to read out it in different sequence for recording.

Fig. 2 shows a configuration of code formed by the encoder as described above. The information symbols are arranged in two dimensions of $(k_1 \times k_2)$. The $k_2$ information symbols in every lateral direction, that is, in every row of the two-dimensional arrangement are subjected to the encoding process for the $C_2$ code. The $k_1$ information symbols in every vertical direction, that is, in every column are subjected to the encoding process for the $C_1$ code. The $C_2$ parity data is also encoded into the $C_1$ code. The $C_1$ code is, for instance, $(n_1, k_1)$ Reed-Solomon code, by which it is possible to correct errors of up to $(n_1 - k_1)/2$ symbols.

The general method of decoding the Reed-Solomon code will be described.

The hamming distance of the $(n,k)$ Reed-Solomon code (where n denotes the code length and k denotes the number of information symbols) on a Galois Field $GF(2^m)$ can be expressed as $(d = n - k + l)$ and the generator polynomial can be expressed as

$$\prod_{i=0}^{d-2} (x + \alpha^i).$$

If the received words are $(r_0, r_1, r_2, \ldots, r_{n-1})$, the syndrome can be obtained by operating the following expression:

$$S_j = \sum_{i=0}^{n-1} r_i \, \alpha^{ij} \quad (j = 0, 1, \ldots, d-2) \quad \ldots \ (1)$$

An error location polynomial $\sigma(z)$ and an error evaluation polynomial $\omega(z)$ are obtained by employing the syndrome $S_j$. As to this method, Euclid's mutual division method, Berlekamp's method, Peterson's method and so on have been proposed.

By solving $\sigma(z) = 0$, the error location $X_i$ can be obtained. For this purpose, a Chien search is employed.

Then, the error value $Y_i$ can be obtained on the basis of the error location $X_i$ and the error evaluation polynomial $\omega(z)$.

The above calculations in the decoding steps are explained with the error location as $X_i$ ($i = 1, 2, \ldots, e : e$ denotes the number of errors), and the error value as $Y_i$. Since the Reed-Solomon code is a linear code, the syndrome can be expressed as:

$$S_j = \sum_{i=1}^{e} Y_i \, X_i^{\ j} \quad (j = 1, 2, \ldots, d-2) \quad \ldots \ (2)$$

if the syndrome is expressed by a polynomial as:

$$S(z) = \sum_{j=0}^{d-2} S_j z^j \quad \cdot \cdot \cdot \cdot (3)$$

a following expression is obtained:

$$S(z) = \sum_{i=1}^{e} Y_i \sum_{j=0}^{d-2} (X_i z)^j$$

$$= \sum_{i=1}^{e} \frac{Y_i}{1 - X_i z} \quad (\text{mod. } z^{d-1}) \quad \cdot \cdot \cdot \cdot (4)$$

If the error location polynomial and the error evaluation polynomial are defined as

$$\sigma(z) = \prod_{j=1}^{e} (1 - X_j z) \quad \cdot \cdot \cdot \cdot (5)$$

$$\omega(z) = \sigma(z) S(z) \tag{6}$$

then $\omega(z)$ can be expressed as

$$\omega(z) = \sum_{i=1}^{e} \frac{Y_i}{1 - X_i z} \prod_{j=1}^{e} (1 - X_j z)$$

$$= \sum_{i=1}^{e} Y_i \prod_{j \neq i}^{e} (1 - X_j z) \quad (\text{mod. } z^{d-1}) \quad \cdot \cdot \cdot \cdot (7)$$

The error value $Y_i$ can be obtained by substituting $X_i^{-1}$ into z and by transforming the expression as follows:

$$Y_i = \omega(X_i^{-1}) / \prod_{j \neq i}^{e} (1 - X_j X_i^{-1}) \quad \cdot \cdot \cdot \cdot (8)$$

As an example, a (32,24) Reed-solomon code having roots of $\alpha^0$ to $\alpha^7$ will be explained. Since this code is (d=8), it is possible to correct errors of up to 4 symbols. If the error locations of the 4 symbols are $X_1$ to $X_4$ and the error values are $Y_1$ to $Y_4$, the syndrome is obtained from following expression.

$$S_j = \sum_{i=1}^{4} Y_i X_i^j \quad (j = 0 \text{ to } 3)$$

Namely, $S_0$ is as follows among 4 syndromes:

$$S_0 = \sum_{i=1}^{4} Y_i$$

Once the error values $Y_1$, $Y_2$, $Y_3$ can be obtained, the remaining error value $Y_4$ is obtained as follows without implementing complicated calculations:

$$Y_4 = S_0 - Y_1 - Y_2 - Y_3$$

In codes on $GF(2^m)$, a subtraction is equivalent to an addition of (mod. 2).

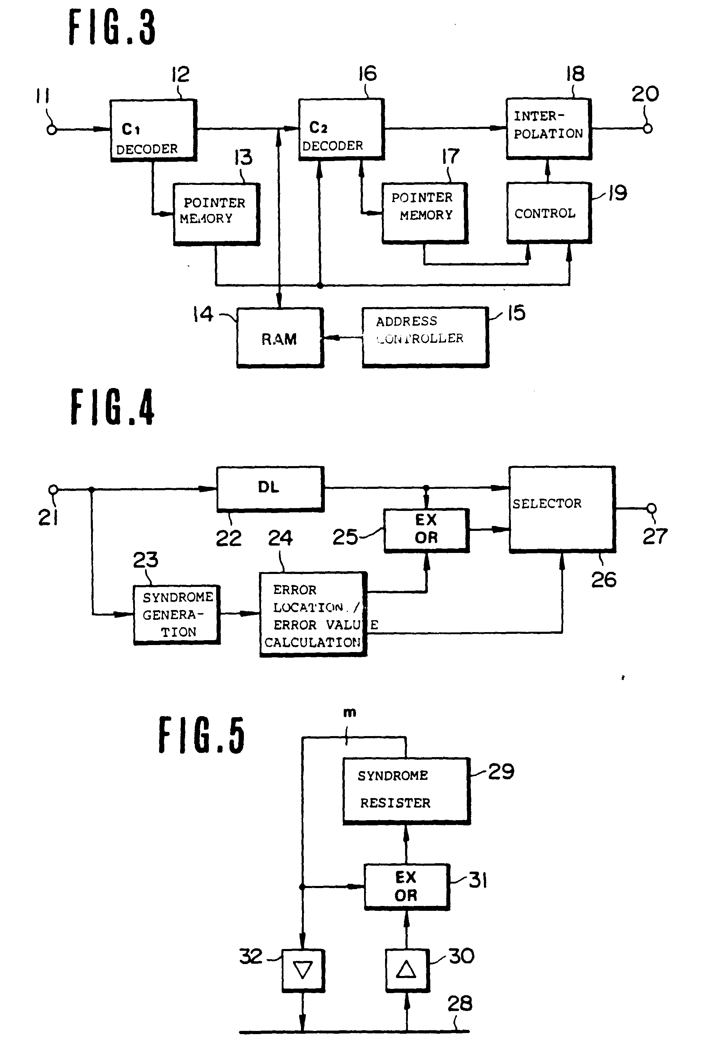

Fig. 3 shows a configuration of the decoder of this embodiment. In Fig. 3, the reproduced data are supplied from an input terminal designated by the reference numeral 11 and to a $C_1$ decoder 12. In the $C_1$ decoder 12, the decoding of the $C_1$ code is performed. All errors of up to $(n_1 - k_1)/2$ symbols are corrected in the $C_1$ decoding. In the case, however, where the number of errors in a single series of $C_1$ code is more than or equal to $(n_1 - k_1)/2$, the $C_1$ pointer of this series is set to "1", the other pointers are set to "0". In Figs. 2 and 3, the reference numeral 13 denotes a pointer memory for storing the pointers of the $C_1$ code, which has $n_2$ bits. The output of the $C_1$ decoder 12 is stored temporarily in a RAM 14 in sequence under the control of an address controller 15.

The output read out from the RAM 14 is supplied to a $C_2$ decoder 16 to be subjected to the decoding of the $C_2$ code. The $C_2$ decoder 16 is supplied with the $C_1$ pointer from the pointer memory 13. Since the $C_1$ pointer is common to the all of $K_1$ series of $C_2$ code, it is possible to decode the $C_2$ code in accordance with the same procedure in each series. The $C_2$ decoder 16 corrects errors of up to $(n_2 - k_2)/2$ symbols and generates one of three kinds of pointers in the $C_2$ code which are stored in a pointer memory 17.

When error correction is perfomed by the $C_2$ decoder 16, the $C_2$ pointer with respect to the series is set to "0". When error correction can not be performed by the $C_2$ decoder 16 and the $C_1$ pointers are used because of their high reliability (described below), the $C_2$ pointer is set to "1". When error correction can not be performed by the $C_2$ decoder 16 and all symbols are determined to be erroneous symbols because of low reliability of the $C_1$ pointer, the $C_2$ pointers are set to "2". Therefore, the $C_2$ pointers have 2 bits and the pointer memory 17 has $2K_1$ bits.

The pointer memories 13 and 17 are disposed separately from the RAM 14 for storing information symbols and parity data in decoding or may be disposed in common with the RAM 14 by using a part of the memory regions of RAM 14.

Without being limited to 1 bit, the $C_1$ pointer may have 2 bits or more. Further, it is possible to implement the error correction code processing of the $C_2$ code for the $C_1$ parity, while providing a $C_2$ pointer memory of $(2n_1)$ bits.

The output data of the $C_2$ decoder 16 is supplied to an interpolation circuit 18 to conceal errors in the symbols which have not been corrected. The interpolation circuit 18 performs the mean value interpolation, for instance. The interpolation circuit 18 is controlled by a control circuit 19 which is supplied with the $C_1$ pointers and the $C_2$ pointers from the pointer memories 13 and 17. The output data of the interpolation circuit 18 is derived at an output terminal 20. The control circuit 19 determines by every information symbol whether interpolation is necessary on the basis of the $c_1$ pointer and $c_2$ pointer. In Fig. 2, There exist all the combinations of $C_1$ pointers designated as 13' and $C_2$ pointers designated as 17'.

When the $C_2$ pointer is "0" irrespective of the fact that the $C_1$ pointer is "0" or "1", the interpolation circuit 18 does not work. When the $C_2$ pointer is "1" and the $C_1$ pointer is "0", since it is determined that the information symbol has no error, no interpolation is done. When the $C_2$ pointer is "1" and the $C_1$ pointer is "1", since it is determined that it is an erroneous symbol, the interpolation operation is performed. Further when the $C_2$ pointer is "2" irrespective of the fact that the $C_1$ pointer is "0" or "1", since it is determined that it is an erroneous symbol, the interpolation operation is performed.

The reliability of the $C_1$ pointers is evaluated by the $C_2$ decoder. For instance, if up to 2 symbol errors can be

corrected by the $C_2$ code, and correction by the $C_2$ code can not be performed in spite of the fact that only one $C_1$ pointer is "1", it is determined that the reliability of the $C_1$ pointer is low because the above is abnormal. Even if errors are not corrected by the $C_2$ code, it is possible to eliminate the necessity of interpolation by providing three kinds 0, 1, 2 of the $C_2$ pointers and by discriminating the copies of $C_1$ pointers from all errors.

In the above mentioned $C_2$ decoder 16, when the $C_1$ pointers are used, erasure correction is made where the total value of the $C_1$ pointers is less than or equal to $(n_2 - k_2)$ and when the erasure correction is made, the $C_2$ pointer is set to "0".

As described above, the decoding of the Reed-Solomon code is performed by calculation of the error location polynomial $\sigma(z)$ and the error evaluation polynomial $\omega(z)$ in every row and by employing the syndrome obtained by $n_2$ symbols in each row. In the case of erasure correction, since the locations where the $C_1$ pointers are "1" are determined as the error locations, it is possible to obtain the error value $Y_i$ from the error location $X_i$ and the error evaluation polynomial $\omega(z)$. That is to say, by substituting $X_i^{-1}$ in place of $z$, $Y_i$ can be obtained as follows, as in expression (8):

$$Y_i = \frac{\omega(X_i^{-1})}{\prod\limits_{j \neq i}^{s} (1 - X_j X_i^{-1})}$$

(where $i = 1, 2, 3, ...s$ ; $s$ denotes the number of symbols) in the above expression, the term of denominator can be determined only by the error locations. For instance, provided that the error locations shown by the $C_1$ pointer are $X_1$, $X_2$, $X_3$, the terms of denominator of the expressions for obtaining the error values $Y_1$, $Y_2$, $Y_3$ are

$$\text{Denominator of } Y_1 : (1 - X_2 X_1^{-1}) (1 - X_3 X_1^{-1})$$

$$\text{Denominator of } Y_2 : (1 - X_1 X_2^{-1}) (1 - X_3 X_2^{-1})$$

$$\text{Denominator of } Y_3 : (1 - X_1 X_3^{-1}) (1 - X_2 X_3^{-1})$$

Here, the pointers stored in the pointer memory 13 are the same in all the $K_1$ series of the $C_2$ code. Therefore, it is sufficient to implement the calculation of the term of the denominator in the above expression to obtain an error value only once with respect to the $k_i$ series.

Fig. 4 shows the configuration of an error correcting decoder for use with the above mentioned $C_1$ and $C_2$ codes. The received data are supplied to an input terminal designated by the reference numeral 21 and supplied to a delay circuit 22 and a syndrome generating circuit 23. The syndromes formed by the syndrome generating circuit 23 are supplied to an error location and error value calculating circuit 24. The error data from the error location and error value calculating circuit 24 are supplied to an exclusive OR gate 25 and added to the received data from the delay circuit 22 in (mod. 2). The received data from the delay circuit 22 and the error corrected data from the exclusive OR gate 25 are supplied to a selector 26. The selector 26 is controlled by the error location data. At the error locations, the output of the exclusive OR gate 25 is selected by the selector 26 to be derived at an output terminal 27 in place of the received data.

In the case of an audio PCM signal recording and reproducing apparatus, the reproduced data are once written in a RAM. By use of the data read out from the RAM, the syndrome is generated and on the basis of which the error locations and the error values are calculated. Fig. 5 shows a part of the error location and error value calculating circuit 24. In Fig. 5, the reference numeral 28 denotes a data bus through which data and syndrome and so on are transferred.

In Fig. 5, the reference numeral 29 denotes a syndrome register in which the syndrome $S_0$ is stored through the data bus 28, a bus buffer 30 and an exclusive OR gate 31. the syndrome $S_0$ has m bits in the case of Reed-Solomon code on $GF(2^m)$. The syndrome $S_0$ from the syndrome register 29 is supplied to the exclusive OR gate 31 and the bus buffer 32.

When the syndrome $S_0$ is stored in the syndrome register 29, the obtained error values $Y_1, Y_2, Y_3$ are supplied to the exclusive OR gate 31 in sequence from the data bus 28 through the bus buffer 30. Therefore, the output of the exclusive OR gate 31 is $(S_0 \oplus Y_1)$, $(S_0 \oplus Y_1 \oplus Y_2)$ and $(S_0 \oplus Y_1 \oplus Y_2 \oplus Y_3 = Y_4)$. The error value $Y_4$ is left in the syndrome register 29. The error value $Y_4$ is outputted to the data bus 28 through the bus buffer 32 to be employed for error correction.

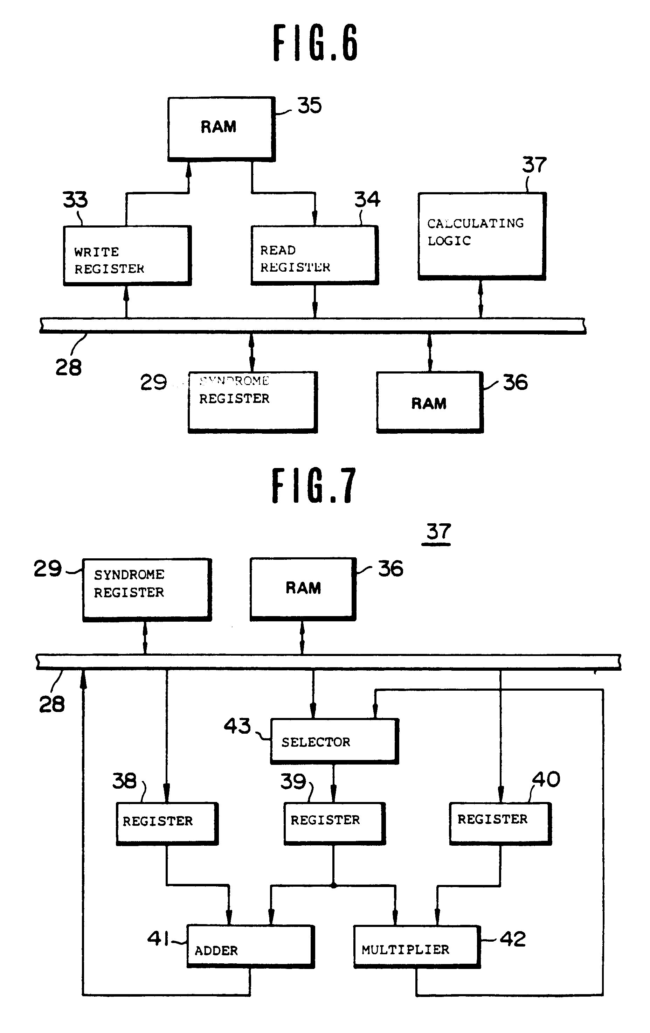

Fig. 6 shows another example of hardware for decoding in an erasure correction. A main RAM 35 is connected to the data bus 28 through a writing register 33 and a reading register 34. The syndrome register 29, a working RAM 36 and an operation logic circuit 37 are also provided to the data bus 28.

The erasure correction by Reed-Solomon code can be obtained by solving the following n-order linear simultaneous equations in the same way as in expression (2):

$$S_\nu = \sum_{k=1}^{n} X_k^{\nu} Y_k \quad \cdot \cdot \cdot \quad (9)$$

where,

$\nu = 0$ to $d - 2$
n : Number of erasures
$X_k$ : Location of kth
$S_\nu$ : Syndrome
$Y_k$ : Magnitude of error in the erasure of kth
d : Minimum distance of code

Here, n, $X_k$, $S_\nu$, are known, $Y_k$ is unknown.

To solve the above equation, the following method has been conventionally adopted: if

$$\Lambda(z) = \prod_{i=1}^{n} (1 - X_i z)$$

$$\omega(z) = S(z) \Lambda(z) \bmod. Z^{d-1}$$

$Y_i$ can be obtained as in expression (8) as follows:

$$Y_i = \omega(X_i^{-1}) / \prod_{j \neq i}^{n} (1 - X_j X_i^{-1}) \quad \cdot \cdot \cdot \quad (10)$$

In this method, however, if the number of actual calculation steps is counted when d = 9 and n = 8, for instance.

(i) Expansion of $\Lambda(z)$

$$\text{Number of multiplications} : 1 + 2 + ..... + 7 = 28$$

$$\text{Number of additions} : 1 + 2 + ..... + 7 = 28$$

(ii) Previous calculations for obtaining the denominator of

$$Y_i \text{ and } Y_i = \prod_{\substack{j \neq i \\ i=I}}^{8} (1 - X_j X_i^{-1})$$

Number of reciprocals : 1 x 8 = 8

Number of multiplications : (7 + 6) x 8 = 104

Number of additions : 7 x 8 = 56

(iii) Calculations for obtaining $\omega(z) = S(z)\ \Lambda(z)$, mod. $Z^8$

Number of multiplications : 1 + 2 + ..... + 7 = 28

Number of additions : 1 + 2 + ..... + 7 = 28

(iv) Calculations for obtaining $\omega(X_i^{-1})$

Number of reciprocals : 1 x 8 = 8

Number of multiplications : 7 x 8 = 56

Number of additions : 7 x 8 = 56

(v) Calculations for obtaining $Y_i$

Number of division : 1 x 8 = 8

When these calculations each need one step, the number of steps is 408 in total.

In the circuit shown in Fig. 6, the roots of expression (9) are calculated by:

$$Y_i = (\sum_{j=0}^{n-1} \Lambda_{nij}\ S_{j+\ell})\ /\ X_i^{\ell}\ \prod_{\substack{k=1\\k\ne i}}^{n}(X_k + X_i)\ \ .\ \ .\ \ .\ \ (11)$$

where

$\Lambda_{nij}$ :  Coefficient of $Z^j$ of

$$[\ \prod_{\substack{k=1\\k\ne i}}^{n}(z + X_k)\ ]$$

$\ell$ :  Any integer more than or equal to 0 which satisfies $\ell \leqq d - n - 1$

That is to say, in order to implement erasure correction, $\ell = 0$, $i = n$ are substituted into the expression (11) as follows:

$$Y_n = (\sum_{j=0}^{n-1} \Lambda_{nnj} \, S_j) \, / \, \prod_{k=1}^{n-1} (X_k + X_n) \quad \cdot \cdot \cdot \quad (11)'$$

By this calculation, $Y_n$ is obtained and $Y_n X_n^v$ is added to each syndrome S as follows:

$$S_v \leftarrow S_v + Y_n X_n^v$$

where $v = 0$ to n-2

Since the data at the location $X_n$ are correct, the syndrome includes (n-1) erasures. Therefore, by reducing n by 1, $Y_{n-1}$ can be obtained:

$$Y_{n-1} = (\sum_{j=0}^{n-2} \Lambda_{n-1,n-1,j} \, S_j) \, / \, \prod_{k=1}^{n-2} (X_k + X_{n-1})$$

By this calculation, $Y_{n-1}$ is obtained and $Y_{n-1} X_{n-1}^v$ is added to each syndrome S as follows:

$$S_v \leftarrow S_v + Y_{n-1} X_{n-1}^v$$

where $v = 0$ to n-3

By repeating the above, the last remaining erasure $Y_1$ can be obtained as

$$Y_1 = S_0$$

As explained above, an erasure correction can be implemented. In this case, the actual number of operation steps is counted in the same way as in the conventional method, provided that $d = 9$ and $n = 8$.

(i) Expansion of $\Lambda_{nnj}$

Number of multiplications : $1 + 2 + ..... + 6 = 21$

Number of additions : $1 + 2 + ..... + 6 = 21$

(ii) Previous calculations for obtaining the denominator of

$$Y_n, \ \Pi_n = \prod_{k=1}^{n-1} (X_k + X_n),$$

where it is sufficient to obtain only $II_3$ to $II_8$, since $II_2 = X_1 + Y_2 = \Lambda_{331}$.

Number of multiplications : $1 + 2 + ..... + 6 = 21$

Number of additions : 1 + 2 + ..... + 6 = 21

(iii) Calculations for obtaining the numerator of $Y_n$

Number of multiplications : 7 + 6 + ..... + 1 = 28

Number of additions : 7 + 6 + ..... + 1 = 28

(iv) Calculations for obtaining $Y_n$, since $Y_1 = S_0$

Number of divisions : 7

(v)

$$S_v \leftarrow S_v + Y_n X_n^v$$

Number of multiplications : 6 + 5 + ..... + 1 = 21

Number of additions : 7 + 6 + ..... + 1 = 28

The number of the above calculations steps is 202 in total.

Therefore, in the case of expression (11), it is possible to reduce the number of calculation steps to 50% of the conventional case in the expression (10).

Further, in the case where the above mentioned correction code is a product code, provided that 30 symbols are arranged in the vertical direction, 128 symbols are arranged in the lateral direction, the $C_1$ code is formed to the vertical direction, and the $C_2$ code is formed to the lateral direction, the erasure corresponds to the location of the $C_1$ pointers, and the location $X_k$ (k=1 to n) is the same in all the $C_2$ code series. This means that it is possible to previously calculate $\Lambda_{nnj}$ and

$$\prod_{k=1}^{n-1} (x_k + x_n)$$

in expression (11)' without calculating these terms every $C_2$ decoding. That is to say, in this example, the above calculation is implemented only once while the $C_2$ decoding is performed 30 times.

Therefore, in the number of the above calculation steps, since the number of the calculations of (i) and (ii) is only once every 30 times of $C_2$ decoding, provided that the number of steps of (i) and (ii) is 90/30 = 3, the total number of steps is 115. compared with that in the conventional method, where the number of steps in (i) and (ii) is 224/3 = 74.7 and the total number of steps is 191.5, it is possible to reduce the number of steps by about 40%.

Accordingly, the method as above described has advantages such that it is possible to markedly reduce the number of calculation steps, processing time, hardware load for processing and so on as compared with the conventional method.

Additionaly, although the above calculations are performed by employing the operation logic 37, in the case where, for example, $S_v \leftarrow S_v + X_i^v Y_i$ is obtained, an arrangement as shown in Fig. 7 is adopted. In Fig. 7, the reference numerals 38, 39, 40 denote registers, the reference numeral 41 denotes an adder, the reference numeral 42 denotes a multiplier, the reference numeral 43 denotes a selector, which are all built in the operation logic 37. In this circuit,

[1] $S_0$ is set to the register 38, $Y_i$ is set to the register 39, and x i is set to the register 40, respectively through the data bus 28 from the syndrome register 29 and the working RAM 36 and so on. $S_0 + Y_i$ is outputted from the adder 41 to the data bus 28.

[2] The content of the multiplier 42, $X_i Y_i$, is fedback to the register 39 through the selector 43, and $S_1$ is set to the register 38 from the data bus 28. Therefore, $S_1 + X_i Y_i$ is outputted from the adder 41 to the data bus 28.

[3] Further, the content of the multiplier 42, $X_i^2 Y_i$ is fedback to the register 39 through the selector 43, and $S_2$ is set to the register 38 from the data bus 28. Therefore, $S_2 + X_i^2 Y_i$ is outputted from the adder 41 to the data bus 28.

[4] By repeating the above steps, $S_3 + X_i^3 Y_i$, $S_4 + X_i^4 Y_i$, .... are obtained sequentially and supplied to the syndrome register 29 through the data bus 28 so as to rewrite each value.

The calculations are implemented as described above.

In the above explanation, although all of $X_1$ to $X_n$ are assumed as erasures, in the case where $X_1$ to $X_{n-1}$ are erasures and $X_n$ is an error, it is possible to correct the symbols. In this case, the number of unknown quantity are $(n+1)$ of $Y_1$ to $Y_n$ and $X_n$. $X_n$ can be obtained by using the above $\Lambda_{nnj}$ as follows:

$$X_n = \frac{\sum_{j=0}^{n-1} \Lambda_{nnj} \, s_{j+\ell+1}}{\sum_{j=0}^{n-1} \Lambda_{nnj} \, s_{j+\ell}} \qquad \cdots \ (12)$$

Therefore, the unknown quantity are $Y_1$ to $Y_n$, and thereafter, this unknown quantity can be obtained in the same way as in the erasure correction.

For instance, in the case where $d = 9$ (6 erasures + 1 error) in product code,

[1] Check locations of the erasures $X_1$, $X_2$, ....., $X_6$.

[2] Obtain and store $\Lambda_{nnj}$, here 21 symbols in total of $\Lambda_{221}=X_1$, $\Lambda_{331}=\Lambda_{221}+X_2$, $\Lambda_{332}=\Lambda_{221} X_2$, ....., $\Lambda_{771}$, ....., $\Lambda_{776}$.

[3] Obtain and store 5 symbols in total of

$$\prod_{k=1}^{n-1} (X_k + X_n)$$

$(n = 2$ to $6)$.

The above processings are made once for each of the decoding cycles 30 times.

[4] Calculate syndromes $S_0$ to $S_7$.

[5] Obtain $X_7$ by an expression as follows:

$$X_7 = \frac{\sum_{j=0}^{6} \Lambda_{77j} \, s_{j+1}}{\sum_{j=0}^{6} \Lambda_{77j} \, s_j}$$

[6] Obtain $Y_7$ by the following expression and feedback the syndrome $Y_7 X_7$ :

$$Y_7 = (\sum_{j=0}^{6} \Lambda_{77j} \, S_j) \,/\, \prod_{k=1}^{n-1} (X_k + X_7)$$

Thereafter, $Y_6$ to $Y_1$ (= $S_0$) are sequentially obtained.

Although a case where expression (11)' is used is shown in this example, the operation is the same if $1 \neq 10$.

As described above, it is possible to implement the correction of errors including erasures and one error. In this case, the number of calculation steps can be reduced as in the erasure correction described above.

The proof of the above expressions (11) and (12) will be described hereinafter:

[Lemma] If

$$\Lambda_{ni}(z) = \prod_{\substack{k=1 \\ k \neq i}}^{n} (z + X_k),$$

$$\Lambda_{nij} = [\Lambda_{ni}(z)]_j$$

the following expression is cleary obtained:

$$\sum_{j=0}^{n-1} \Lambda_{nij} \, z^j = \prod_{\substack{k=1 \\ k \neq i}}^{n} (z + X_k),$$

[Theorem 1] The n-order linear simultaneous equations:

$$S_\nu = \sum_{k=1}^{n} X_k^\nu \, Y_k$$

($\nu$ = 0 to n-1 : $Y_i$ is unknown quantity) has the roots as:

$$Y_i = (\sum_{j=0}^{n-1} \Lambda_{nij} \, S_j) \,/\, \prod_{\substack{k=1 \\ k \neq i}}^{n} (X_k + X_i)$$

(Proof)

$$\text{Right side} = \left( \sum_{j=0}^{n-1} \Lambda_{nij} \sum_{k=1}^{n} X_k{}^j Y_k \right) / \prod_{\substack{k=1 \\ k \neq i}}^{n} (X_k + X_i)$$

$$= \left( \sum_{k=1}^{n} Y_k \sum_{j=0}^{n-1} \Lambda_{nij} X_k{}^j \right) / \prod_{\substack{k=1 \\ k \neq i}}^{n} (X_k + X_i)$$

$$= \left( \sum_{k=1}^{n} Y_k \prod_{\substack{j=1 \\ j \neq i}}^{n} (X_k + X_j) \right) / \prod_{\substack{k=1 \\ k \neq i}}^{n} (X_k + X_i)$$

$$= \left( Y_i \prod_{\substack{j=1 \\ j \neq i}}^{n} (X_k + X_j) \right) / \prod_{\substack{k=1 \\ k \neq i}}^{n} (X_k + X_i)$$

$$= Y_i$$

(Corollary 1)

$$Y_i = \left( \sum_{j=0}^{n-1} \Lambda_{nij} s_{j+\ell} \right) / X_i{}^\ell \prod_{\substack{k=1 \\ k \neq i}}^{n} (X_k + X_i)$$

$$(\ell \geq 0)$$

(Proof) It is clearly proved by substituting into the above:

$$s_{j+\ell} = \sum_{k=1}^{n} X_k{}^{j+\ell} Y_k$$

[Theorem 2] If $X_i$ to $X_{n-1}$ : Erasure and $X_n$ is an error,

$$X_n = \frac{\displaystyle\sum_{j=0}^{n-1} \Lambda_{nnj} s_{j+\ell+1}}{\displaystyle\sum_{j=0}^{n-1} \Lambda_{nnj} s_{j+\ell}}$$

(Proof) From Corollary 1,

$$\text{Right side} = \frac{Y_n \, X_n^{\ell+1} \, \prod_{k=1}^{n-1} (X_k + X_n)}{Y_n \, X_n^{\ell} \, \prod_{k=1}^{n-1} (X_k + X_n)} = \text{Left side}$$

Therefore, it is understood from Theorem 1 that errors can be corrected in the erasure correction by use of any of $S_1$ to $S_n$, $S_2$ to $S_{n+1}$, ..... , $S_{d-1-n}$ to $S_{d-2}$ among the series cf $S_0$ to $S_{n-1}$. That is, n continuous syndromes are necessary for n erasure corrections, the remaining syndromes are usable for checking, so that $n \leq d-1$.

Further, to obtain $X_n$ from theorem 2, a total of n+1 syndromes of $S_\ell$ to $S_{n+\ell}$ are necessary, so that $n \leq d-2$. In this case, the number of erasures is $n-1 \leq d-3$. The remaining syndromes can be used for checking as in the above case.

In the conventional method, the pointer areas are required for the total number of data ($n_1$, $n_2$) corresponding to the error correction code. According to the present invention, however it is possible to reduce the number of pointers to ($n_2 + 2n_1$) and further to reduce the capacity of the memory required in decoding Further, according to the present invention, it is possible to reduce the number of steps for writing or reading the pointers. Further, according to the present invention, in the case where the erasure correction in the $C_2$ decoding is implemented by the use of pointers formed by the C1 decoding, since the pattern of the pointers with respect to each series of $C_2$ code is common and a part of the operations to obtain error value becomes common, it is possible to implement the operation only once. Therefore it is possible to markedly reduce the number of processing steps in decoding and to realize a high-speed in decoding operation.

Furthermore, according to the present invention, without necessity to obtain the whole error values in accordance with complicated error evaluation polynomial in obtaining a plurality of error values, it is possible to obtained one of the error values by a simple construction and to reduce the number of the processing steps.

Moreover, according to the present invention, it is possible to markedly reduce the number of calculation steps in erasure correction.

The present application describes matter described parent application EP-A-167 627 from which this application was divided.

## Claims

1. A method for decoding a product error correction code of respective first error correction codes ($n_1$, $k_1$), where $n_1$ denotes the code length and $k_1$ is the number of information symbols, and respective second error correction codes ($n_2$, $k_2$), where $n_2$ denotes the code length and $k_2$ is the number of information symbols, the first correcting codes being arranged in columns and the second correcting codes being arranged in rows of a two-dimensional arrangement, the method comprising the steps of:

   receiving at least the respective first error correction codes;
   first decoding the respective first error correction codes;
   generating respective first pointers for indicating whether the errors of respective first error correction codes can be corrected;
   storing the respective first pointers in memory means (13) having at least $n_2$ bits;
   second decoding the respective second error correction codes by implementing an erasure correction where the first pointers indicate errors that cannot be corrected; and
   outputting the information symbols; the step of second decoding includes a step of calculating error values of erasure symbols by an algebraic expression consisting of a first term, which is a common value, and a second term, which comprises individually independent values for the erasure error corrections of the respective second error correction codes; and
   the step of calculating error values comprises: performing a first calculation of the first term only once for each of the respective first pointers; storing the result of the first calculation of the first term; and performing each calculation to obtain error values for the respective second error correction codes by calculating each second term and using the stored result of the first calculation.

2. An apparatus for decoding a product error correction code of respective first error correction codes $(n_1, k_1)$, where $n_1$ denotes the code length and $k_1$ is the number of information symbols and respective second error correction codes $(n_2, k_2)$, where $n_2$ denotes the code length and $k_2$ is the number of information symbols, the first correction codes being arranged in columns and the second correction codes being arranged in rows of a two-dimensional arrangement, the apparatus comprising:

receiving and output means (28) for receiving at least the respective first error correction codes and for deriving the information symbols;

decoding means (12, 14, 16, 29, 33 - 37) connected to said receiving and output means (28) and for first decoding the respective first error correction codes and for generating respective first pointers for indicating whether the errors of respective first error correction codes can be corrected and for second decoding the respective second error correction codes by implementing an erasure correction where the first pointers indicate errors that cannot be corrected and memory means (13) connected to said decoding means (29, 33 - 37) and having a capacity of at least $n_2$ bits for storing the respective first pointers;

said decoding means (12, 14, 16; 29, 33-37) calculating, in said second decoding, error values of erasure symbols using an algebraic expression consisting of a first term, which is a common value, and a second term, which comprises individually independent values for the erasure error corrections of the respective second error correction codes; and

said decoding means (12, 13, 16; 29, 33 - 37) performing a first calculation of the first term only once corresponding to each of the respective first pointers, and to storing the result of the first calculation of the first term; and further performing each calculation to obtain error values for the respective second error correction codes by calculating each second term and using the stored result of the first calculation.

3. An apparatus according to claim 2 wherein said decoding means (12, 14, 16, 29, 33-37) comprises first decoding means (12, 14) connected to said receiving means (11) for said first decoding, and second decoding means (16, 14) connected to said first decoding means (12, 14) and said memory means (13) for said second decoding, and said apparatus further comprises storing means for storing the result of the first calculation of the said first term and implements each of the calculations for obtaining error values corresponding to the respective second error correction codes by each of second calculations of the second term and by using the stored result of the first correction.

4. A method according to claim 1 further comprising the steps, for decoding and correcting Reed=Solomon code of:

solving the expression

$$S_\nu = \sum_{k=1}^{n} X_k^{\nu} \, Y_k$$

where,

$\nu = 0$ to $d - 2$
$n$ : Number of erasure
$X_k$ : Location of kth element
$S_\nu$ : Syndrome
$Y_k$ : Magnitude of error in the erasure of kth element
$d$ : Minimum distance of code

to obtain roots of the expression;
making erasure correction of errors encoded in the Reed=Solomon code in accordance with the roots, where the roots are obtained by solving the expression

$$Y_i = (\sum_{j=0}^{n-1} \Lambda_{nij} \, S_{j+\ell}) \; / \; x_i^{\ell} \prod_{\substack{k=1 \\ k \neq i}}^{n} (X_k + X_i)$$

where

$\Lambda_{nij}$ :  Coefficient of $Z^j$ of

$$[\prod_{\substack{k=1 \\ k \neq i}}^{n} (z + X_k)]$$

$\ell$ :  Any integer more than or equal to 0 which satisfies $\ell < d - n - 1$.

5.  Apparatus according to claims 2 or 3 for decoding and correcting erasure in Reed-Solomon code in accordance with the roots of

$$S_\nu = \sum_{k=1}^{n} X_k^{\nu} Y_k$$

where,

$\nu = 0$ to $d - 2$
n : Number of erasure
$X_k$ : Location of kth element
$S_\nu$ : Syndrome
$Y_k$ : Magnitude of error in the erasure of kth element
d : Minimum distance of the code

wherein said decoding means (12, 14, 16; 28, 29, 33-37) further comprises
  syndrome register means (29) for storing syndrome $S_\nu$; and
  operating logic means (37) for obtaining the roots $Y_i$ by solving the expression:

$$Y_i = (\sum_{j=0}^{n-1} \Lambda_{nij} \, S_{j+\ell}) \; / X_i^{\ell} \prod_{\substack{k=1 \\ k \neq i}}^{n} (X_k + X_i)$$

where

$\Lambda_{nij}$ :  Coefficient of $Z^j$ of

$$[\prod_{\substack{k=1 \\ k \neq i}}^{n} (z + X_k)]$$

$\ell$ :          Any integer more than or equal to 0 which satisfies $\ell \leq d - n - 1$

said operating logic means (37) including

register means (38) for storing syndrome $S_v$;
register means (39) for storing $X_i^v Y_i$;
register means (40) for storing $X_i$;
adder means (41) for adding $S_v$ and $X_i^v Y_i$ and for supplying said register means (38) and syndrome register means (29) with $S_v + X_i^v Y_i$;
multiplier means (42) for multiplying $X_i$ and $X_i^v Y_i$ and for supplying said register means (39) with $X_i^v Y_i$.

## Patentansprüche

1. Verfahren zum Decodieren eines Produkt-Fehlerkorrekturcodes von jeweiligen ersten Fehlerkorrekturcodes ($n_1$, $k_1$), wobei $n_1$ die Codelänge und $k_1$ die Anzahl der Informationssymbole bezeichnet, und jeweiligen zweiten Fehlerkorrekturcodes ($n_2$, $k_2$), wobei $n_2$ die Codelänge und $k_2$ die Anzahl der Informationssymbole bezeichnet, wobei die ersten Korrekturcodes in Spalten und die zweiten Korrekturcodes in Zeilen einer zweidimensionalen Anordnung angeordnet sind, wobei das Verfahren die folgenden Schritte umfaßt:

Empfangen zumindest der jeweiligen ersten Fehlerkorrekturcodes;
erstes Decodieren der jeweiligen ersten Fehlerkorrekturcodes;
Erzeugen jeweiliger erster Zeiger zum Anzeigen, ob die Fehler der jeweiligen ersten Fehlerkorrekturcodes korrigiert werden können;
Speichern der jeweiligen ersten Zeiger in Speichermitteln (13), die wenigstens $n_2$ Bits haben;
zweites Decodieren der jeweiligen zweiten Fehlerkorrekturcodes durch Ausführen einer Löschkorrektur dort, wo die ersten Zeiger Fehler anzeigen, die nicht korrigiert werden können; und
Ausgeben der Informationssymbole; wobei der Schritt des zweiten Decodierens einen Schritt der Berechnung der Fehlerwerte der Löschsymbole durch einen algebraischen Ausdruck bestehend aus einem ersten Term, der ein gemeinsamer Wert ist, und einem zweiten Term, der individuelle unabhängige Werte für die Löschfehlerkorrekturen der jeweiligen zweiten Korrekturcodes umfaßt, beinhaltet; und

wobei der Schritt des Berechnens der Fehlerwerte umfaßt:

Ausführen einer ersten Berechnung des ersten Terms nur einmal für die jeweiligen ersten Zeiger; Speichern des Ergebnisses der ersten Berechnung des ersten Terms; und Ausführen jeder Berechnung, um Fehlerwerte für die jeweiligen zweiten Fehlerkorrekturcodes durch Berechnung jedes zweiten Terms und Verwendung des gespeicherten Ergebnisses der ersten Berechnung zu erlangen.

2. Vorrichtung zum Decodieren eines Produkt-Fehlerkorrekturcodes von jeweiligen ersten Fehlerkorrekturcodes ($n_1$, $k_1$), wobei $n_1$ die Codelänge und $k_1$ die Anzahl der Informationssymbole bezeichnet, und von jeweiligen zweiten Fehlerkorrekturcodes ($n_2$, $k_2$), wobei $n_2$ die Codelänge und $k_2$ die Anzahl der Informationssymbole bezeichnet, wobei die ersten Korrekturcodes in Spalten und die zweiten Korrekturcodes in Zeilen einer zweidimensionalen Anordnung angeordnet sind, wobei die Vorrichtung aufweist:

Empfangs- und Ausgabemittel (28) zum Empfangen zumindest der jeweiligen ersten Fehlerkorrekturcodes und zum Ableiten der Informationssymbole;
Decodiermittel (12, 14, 16; 29, 33-37), die mit den Empfangs- und Ausgabemitteln (28) verbunden sind, und zum ersten Decodieren der jeweiligen ersten Fehlerkorrekturcodes und zum Erzeugen von jeweiligen ersten Zeigern zum Anzeigen, ob die Fehler der jeweiligen ersten Fehlerkorrekturcodes korrigiert werden können, und zum zweiten Decodieren der jeweiligen zweiten Fehlerkorrekturcodes durch die Durchführung einer Löschkorrektur dort, wo die ersten Zeiger Fehler anzeigen, die nicht korrigiert werden können, und Speichermitteln (13), die mit den Decodiermitteln (29, 33-37) verbunden sind und eine Kapazität von wenigstens $n_2$ Bits haben zum Speichern der jeweiligen ersten Zeiger;
wobei die Decodiermittel (12, 14, 16; 29, 33-37) bei der zweiten Decodierung Fehlerwerte der Löschsymbole unter Verwendung eines algebraischen Ausdrucks bestehend aus einem ersten Term, der ein gemeinsamer Wert ist, und einem zweiten Term, der individuelle unabhängige Werte für die Löschfehlerkorrekturen der jeweiligen zweiten Fehlerkorrekturcodes umfaßt, berechnen; und

wobei die Decodiermittel (12, 14, 16; 29, 33-37) eine erste Berechnung des ersten Terms nur einmal entsprechend jedem der jeweiligen ersten Zeiger ausführt, und das Ergebnis der ersten Berechnung des ersten Terms speichert; und ferner jede Berechnung ausführt, um Fehlerwerte für die jeweiligen zweiten Fehlerkorrekturcodes durch Berechnung jedes zweiten Terms und der Verwendung des gespeicherten Ergebnisses der ersten Berechnung zu erlangen.

3. Vorrichtung gemäß Anspruch 2,
wobei die Decodiermittel (12, 14, 16; 29, 33-37) erste Decodiermittel (12, 14), die mit den Empfangsmitteln (11) für die erste Decodierung verbunden sind, und zweite Decodiermittel (16, 14), die mit den ersten Decodiermitteln (12, 14) und dem Speichermittel (13) für die zweite Decodierung verbunden sind, umfaßt, und wobei die Vorrichtung ferner Speichermittel zum Speichern des Ergebnisses der ersten Berechnung des ersten Terms umfaßt und jede der Berechnungen zum Erlangen der Fehlerwerte entsprechend der jeweiligen zweiten Fehlerkorrekturcodes durch jede der zweiten Berechnungen des zweiten Terms und durch Verwendung des gespeicherten Ergebnisses der ersten Korrektur durchführt.

4. Verfahren gemäß Anspruch 1,
ferner umfassend die Schritte zum Decodieren und Korrigieren eines Reed-Solomon-Codes durch Lösen des Ausdrucks:

$$S_\nu = \sum_{k=1}^{n} X_k^\nu Y_k$$

wobei

$\nu = 0$ bis $d - 2$
$n$ : Zahl der Löschung
$X_k$: Ort des k-ten Elements
$S_\nu$: Syndrom
$Y_k$: Größe des Fehlers bei dem Löschen des k-ten Elements
$d$ : minimaler Abstand des Codes,

um Wurzeln dieses Ausdrucks zu erlangen;
Durchführen der Löschkorrektur des Fehlers, der in dem Reed-Solomon-Code gemäß den Wurzeln codiert sind, wobei die Wurzeln durch Lösen des folgenden Ausdrucks erlangt werden:

$$Y_i = \left(\sum_{j=0}^{n-1} \Lambda_{nij} S_{j+l}\right) / X_i^l \prod_{\substack{k=1 \\ k \neq i}}^{n} (X_k + X_i)$$

wobei

$\Lambda_{nij}$:  Koeffizienten von $Z^j$ von

$$\left[\prod_{\substack{k=1 \\ k \neq i}}^{n} (z + X_k)\right]$$

$l$ :  irgendeine ganze Zahl, die größer oder gleich 0 ist, die $\ell < d - n - 1$ erfüllt.

5. Vorrichtung gemäß Anspruch 2 oder 3,
zum Decodieren und Korrigieren des Fehlers in dem Reed-Solomon-Code gemäß den Wurzeln von

$$S_\nu = \sum_{k=1}^{n} X_k^\nu Y_k$$

wobei

$\nu = 0$ bis d - 2
n : Zahl der Löschung
$X_k$: Ort des k-ten Elements
$S_\nu$: Syndrom
$Y_k$: Größe des Fehlers bei dem Löschen des k-ten Elements
d : minimaler Abstand des Codes,

wobei die Decodiermittel (12, 14, 16; 28, 29, 33-37) ferner umfassen:
Syndrom-Registermittel (29) zum Speichern des Syndroms $S_\nu$; und Arbeitslogikmittel (37) zum Erlangen der Wurzeln $Y_i$ durch Lösen des folgenden Ausdrucks:

$$Y_i = (\sum_{j=0}^{n-1} \Lambda_{nij} S_{j+l}) / X_i^l \prod_{\substack{k=1 \\ k \neq i}}^{n} (X_k + X_i)$$

wobei

$\Lambda_{nij}$: Koeffizienten von $Z^j$ von

$$[\prod_{\substack{k=1 \\ k \neq i}}^{n} (z + X_k)]$$

l : irgendeine ganze Zahl, die größer oder gleich 0 ist, die $\ell \leq$ d - n- 1 erfüllt,

wobei

die Arbeitslogikmittel (37) aufweisen
Registermittel (38) zum Speichern des Syndroms $S_\nu$;
Registermittel (39) zum Speichern von $X_i^\nu Y_i$;
Registermittel (40) zum Speichern von $X_i$;
Addiermittel (41) zum Addieren $S_\nu$ und $X_i^\nu Y_i$ und zum Zuführen zu dem Registermittel (38) und zu dem Syndrom-Registermittel (29) von $S_\nu + X_i^\nu Y_i$;
Multipliziermittel (42) zum Multiplizieren von $X_i$ und $X_i^\nu Y_i$ und zum Zuführen von $X_i^\nu Y_i$ zu dem Registermittel (39).

## Revendications

1. Procédé pour décoder un code de correction d'erreurs de produit de premiers codes de correction d'erreurs respectifs ($n_1$, $k_1$), où $n_1$ indique la longueur du code et $k_1$ est le nombre de symboles d'information, et de seconds codes de correction d'erreurs respectifs ($n_2$, $k_2$), où $n_2$ indique la longueur du code et $k_2$ est le nombre de symboles d'informations, les premiers codes de correction étant disposés dans des colonnes et les seconds codes de correction étant disposés sur des lignes d'une disposition à deux dimensions, le procédé comprenant les étapes qui consistent à :

recevoir au moins les premiers codes de correction d'erreurs respectifs ;
décoder en premier les premiers codes de correction d'erreurs respectifs ;
générer des premiers pointeurs respectifs pour indiquer si les erreurs des premiers codes de correction d'erreurs respectifs peuvent être corrigées ;
mémoriser les premiers pointeurs respectifs dans un moyen de mémoire (13) comportant au moins $n_2$ bits ;
décoder en second les seconds codes de correction d'erreurs respectifs en réalisant une correction d'effacement quand les premiers pointeurs indiquent des erreurs qui ne peuvent pas être corrigées ; et,
sortir les symboles d'information,
où l'étape d'un second décodage comprend une étape de calcul de valeurs d'erreur d'effacement de symboles par une expression algébrique constituée d'un premier terme, qui est une valeur commune, et d'un second terme, qui comprend des valeurs individuellement indépendantes pour les corrections d'erreurs d'effacement des seconds codes de correction d'erreurs respectifs ; et,
l'étape de calcul des valeurs d'erreur comprend :
l'exécution d'un premier calcul du premier terme une seule fois pour chacun des premiers pointeurs respectifs ;
la mémorisation du résultat du premier calcul du premier terme ; et l'exécution de chaque calcul pour obtenir des valeurs d'erreur pour les seconds codes de correction d'erreurs respectifs en calculant chaque second terme et en utilisant le résultat du premier calcul mémorisé.

2. Dispositif pour décoder un code de correction d'erreurs de produit de premiers codes de correction d'erreurs res-pectifs ($n_1$, $k_1$), où $n_1$ indique la longueur du code et $k_1$ est le nombre de symboles, et de seconds codes de correction d'erreurs respectifs ($n_2$, $k_2$), où $n_2$ indique la longueur du code et $k_2$ est le nombre de symboles, les premiers codes de correction étant disposés dans des colonnes et les seconds codes de correction étant disposés sur des lignes d'une disposition à deux dimensions, le dispositif comprenant :

un moyen récepteur et de sortie (28) pour recevoir au moins les premiers codes de correction d'erreurs respectifs et pour dériver les symboles d'information ;
un moyen décodeur (12, 14, 16 ; 29, 33 - 37) connecté audit moyen récepteur et de sortie (28) et pour décoder en premier les premiers codes de correction d'erreurs respectifs et pour générer des premiers pointeurs respectifs afin d'indiquer si les erreurs des premiers codes de correction d'erreurs respectifs peuvent être corrigées et pour décoder en second les seconds codes de correction d'erreurs respectifs en réalisant une correction d'effacement si les premiers pointeurs indiquent des erreurs qui ne peuvent pas être corrigées ;
et un moyen de mémoire (13) connecté audit moyen décodeur (29, 33 - 37) et ayant une capacité d'au moins $n_2$ bits pour mémoriser les premiers pointeurs respectifs ;
ledit moyen décodeur (12, 14, 16 ; 29, 33 - 37) calculant des valeurs d'erreur d'effacement de symboles, dans ledit second décodage, en utilisant une expression algébrique composée d'un premier terme, qui est une valeur commune, et d'un second terme, qui comprend des valeurs individuellement indépendantes pour les corrections d'erreurs d'effacement des seconds codes de correction d'erreurs respectifs ; et,
ledit moyen décodeur (12, 14, 16 ; 29, 33 - 37) exécutant un premier calcul du premier terme une seule fois en correspondance avec chacun des premiers pointeurs respectifs, et mémorisant le résultat du premier calcul du premier terme ; et exécutant en outre chaque calcul pour obtenir des valeurs d'erreur pour les seconds codes de correction d'erreurs respectifs par le calcul de chaque second terme et l'utilisation du résultat du premier calcul mémorisé.

3. Dispositif selon la revendication 2, dans lequel ledit moyen décodeur (12, 14, 16 ; 29, 33 - 37) comprend un premier moyen décodeur (12, 14) connecté audit moyen récepteur (11) pour ledit premier décodage, et un second moyen décodeur (16, 14) connecté audit premier moyen décodeur (12, 14) et audit moyen de mémoire (13) pour ledit second décodage, et ledit dispositif comprend en outre un moyen de mémorisation pour mémoriser le résultat du premier calcul dudit premier terme et exécute chacun des calculs pour obtenir des valeurs d'erreur correspondant aux seconds codes de correction d'erreurs respectifs par chacun de seconds calculs du second terme et par l'utilisation du résultat de la première correction mémorisé.

4. Procédé selon la revendication 1, comprenant en outre des étapes, pour décoder et corriger un code de Reed-Solomon, consistant à : résoudre l'équation

$$S_v = \sum_{k=1}^{n} X_k^{\ v} \ Y_k$$

où,

$v = 0$ à d-2

n : Numéro de l'effacement

$X_k$ : Emplacement du k$^{ième}$ élément

$S_v$ : Syndrome

$Y_k$ : Grandeur de l'erreur dans l'effacement du k$^{ième}$ élément

d : Distance minimale du code pour obtenir les racines de l'expression ;

exécuter une correction d'erreurs d'effacement codées dans le code de Reed-Solomon selon les racines, où les racines sont obtenues en résolvant l'expression

$$Y_i = (\sum_{j=0}^{n-1} \Lambda_{nij} \ S_{j+\ell}) \ / \ X_i^{\ell} \prod_{\substack{k=1 \\ k \neq i}}^{n} (X_k + X_i)$$

où

$\Lambda_{nij}$ : \qquad coefficient de $Z^j$ de

$$\left[ \prod_{\substack{k=1 \\ k \neq i}}^{n} (z + X_k) \ \right]$$

$\ell$ : \qquad Tout entier supérieur ou égal à 0 qui satisfait $\ell < d - n - 1$.

**5.** Dispositif selon la revendication 2 ou 3 pour décoder et corriger un effacement dans un code de Reed-Solomon selon les racines de

$$S_v = \sum_{k=1}^{n} X_k^{\ v} \ Y_k$$

où,

$v = 0$ à d-2

n : Numéro de l'effacement

$X_k$ : Emplacement du k$^{ième}$ élément

$S_v$ : Syndrome

$Y_k$ : Grandeur de l'erreur dans l'effacement du k$^{ième}$ élément

d : Distance minimale du code

où ledit moyen décodeur (12, 14, 16 ; 28, 29, 33 - 37) comprend en outre :

un moyen de registre de syndrome (29) pour mémoriser un syndrome $S_v$ ; et

un moyen logique de traitement (37) pour obtenir les racines $Y_i$ par la résolution de l'expression :

$$Y_i = (\sum_{\substack{j=0}}^{n-1} \Lambda_{nij} \, S_{j+\ell}) \; / \; X_i^{\ell} \prod_{\substack{k=1 \\ k \neq i}}^{n} (X_k + X_i)$$

où

$\Lambda_{nij}$ :  Coefficient de $Z^j$ de

$$\left[ \prod_{\substack{k=1 \\ k \neq i}}^{n} (Z + X_k) \right]$$

$\ell$ :  Tout entier supérieur ou égal à 0 qui satisfait $\ell \leq d - n - 1$

ledit moyen logique de traitement (37) incluant :
un moyen de registre (38) pour mémoriser un syndrome $S_v$ ;
un moyen de registre (39) pour mémoriser $X_i^v \, Y_i$ ;
un moyen de registre (40) pour mémoriser $X_i$ ;
un moyen additionneur (41) pour additionner $S_v$ et $X_i^v \, Y_i$ et pour fournir audit moyen de registre (38) et audit moyen de registre de syndrome (29) la valeur de $S_v + X_i^v \, Y_i$ ;
un moyen multiplicateur (42) pour multiplier $X_i$ et $X_i^v \, Y_i$ , et pour fournir audit moyen de registre (39) la valeur de $X_i^v \, Y_i$.

# FIG.1

# FIG.2

# FIG.3

11 ○→ **C₁ DECODER** (12) → **C₂ DECODER** (16) → **INTER-POLATION** (18) → ○ 20

**POINTER MEMORY** (13)

**POINTER MEMORY** (17)

**CONTROL** (19)

**RAM** (14) ← **ADDRESS CONTROLLER** (15)

# FIG.4

21 ○ → **DL** (22) → **SELECTOR** (26) → ○ 27

**SYNDROME GENERATION** (23) → **ERROR LOCATION / ERROR VALUE CALCULATION** (24)

**EX OR** (25)

# FIG.5

m

**SYNDROME RESISTER** (29)

**EX OR** (31)

∇ (32)     △ (30)

28

# FIG.6

```
                    ┌──────────┐  35
                    │   RAM    │
                    └──────────┘
      33                 ↑  ↓              37
  ┌──────────┐    ┌──────────┐      ┌──────────────┐
  │  WRITE   │    │   READ   │ 34   │ CALCULATING  │
  │ REGISTER │    │ REGISTER │      │    LOGIC     │
  └──────────┘    └──────────┘      └──────────────┘
       ↑  ↓            ↑  ↓               ↑  ↓
═══════════════════════════════════════════════════
   28
        29    ┌──────────────┐      ┌──────────┐  36
              │   SYNDROME   │      │   RAM    │
              │   REGISTER   │      │          │
              └──────────────┘      └──────────┘
```

# FIG.7